# EUROPEAN PATENT SPECIFICATION

(11) **EP 4 113 843 B1**
(45) Date of publication and mention of the grant of the patent: **18.02.2026**
(21) Application number: 20942503.2
(22) Date of filing: 28.06.2020
(51) Int. Cl.: H01P 1/12, H01H 1/00, H01H 59/00

(54) **IN-PLANE SLIDING PARALLEL CAPACITIVE RADIO FREQUENCY SWITCH BASED ON FLOATING POTENTIAL**
AUF SCHWEBENDEM POTENTIAL BASIERENDER GLEITPARALLELER KAPAZITIVER HOCHFREQUENZSCHALTER
COMMUTATEUR DE RADIOFRÉQUENCES CAPACITIF PARALLÈLE COULISSANT DANS LE PLAN BASÉ SUR UN POTENTIEL FLOTTANT

(43) Date of publication of application: 04.01.2023
(73) Proprietor: Research Institute of Tsinghua University in Shenzhen, Shenzhen, Guangdong 518057 (CN); Tsinghua University, Haidian District, Beijing 100084 (CN)
(72) Inventor: ZHENG, Quanshui, Beijing 100084 (CN); XIANG, Xiaojian, Beijing 100084 (CN)
(74) Representative: Prinz & Partner mbB
(86) International application number: PCT/CN2020/098479
(87) International publication number: WO 2022/000122

(56) References cited:
- EP-A1- 3 503 284
- CN-A- 1 601 902
- CN-A- 109 979 768
- CN-A- 110 646 060
- CN-A- 110 853 985
- US-A- 5 121 089
- XUANYU HUANG ET AL: "Superlubric Nanogenerators with Superb Performances", ARXIV.ORG, CORNELL UNIVERSITY LIBRARY, 201 OLIN LIBRARY CORNELL UNIVERSITY ITHACA, NY 14853, 12 November 2019 (2019-11-12), XP081530753

## Description

### TECHNICAL FIELD

The present disclosure belongs to the technical field of a radio frequency micro-electromechanical system switch (RF MEMS Switch) and, in particular, to an in-plane sliding parallel capacitive RF switch based on a floating potential.

### BACKGROUND

With the development of radar and wireless communication technology and the development of miniaturization and integration of the RF devices, the RF devices with small size, low power, high performance, and multiple functions have become the development trend in the radio field and MEMS switches emerge as the times require. RF MEMS switches have gradually replaced traditional GaAs field effect transistor (FET) switches and become the development direction of RF switches. Compared with the traditional switches, the RF MEMS switches have the advantages of lower insertion loss, higher isolation, better linearity, lower power consumption, smaller size and the like, can be easily integrated with IC circuits, and have a broad application foreground. At present, the existing RF MEMS switches mainly include an electrostatic drive mechanism, a thermal drive mechanism, an electromagnetic drive mechanism, a piezoelectric drive mechanism and other drive manners.

Compared with the traditional P-I-N diode switch and FET transistor switch, the RF MEMS electrostatic switch, which is a basic electronic component, has the characteristics of lower power consumption, lower insertion loss, lower crosstalk, higher isolation, and higher linearity and is considered to be one of the most important MEMS devices. In particular, with the rapid development of 5G communication systems, radar systems, satellite communication systems, and high-performance RF chip systems in recent years, the industry has higher requirements for the characteristic of the underlying RF switch such as the power consumption, reliability, isolation, linearity, and power handling capability. For example, a long term evolution-advanced (LTE-A) antenna switch with a carrier aggregation function in the 5G system must satisfy the requirement that IIP3 = 90 dBm, while the RF MEMS switch is the only switch that can satisfy that IIP3 > 90 dBm. Since traditional solid-state semiconductor switches (the P-I-N switch and the FET switch) realize the conduction through the doped carriers and exist the contact barriers, the switches present relatively poor quality factor (Ron × Coff) and have a leakage current in an off state which causes a higher insertion loss, lower isolation, and lower linearity of the switches, thereby making this type of switches unsuitable for switching high-frequency RF signals. The RF MEMS electrostatic switch conducts RF signals through the mechanical contact and has physical isolation between signal lines so that the RF MEMS electrostatic switch has low power consumption (nj), low insertion loss, and high isolation and high linearity, thereby greatly reducing power consumption and costs of wireless communication systems, radar detection systems and satellite systems, improving the transmission fidelity of RF signals, and significantly improving the overall performance of the systems. The development and application of the RF MEMS electrostatic switch have become key technologies for advanced electronic equipment such as wireless communication (5G) systems, radar systems, and satellite systems.

Compared with widely applied semiconductor RF switches, although the RF MEMS electrostatic switch has many advantages, an on-off manner of mechanical contact brings serious problems in reliability. The contacts or insulating layer of the RF MEMS electrostatic switch may be easily damaged in high-speed collisions, resulting in an increase in on-resistance, thereby causing a relatively strong thermal effect and a device failure. At the same time, damage to the insulating layer also exacerbates the accumulation of surface charges. When the charge accumulation exceeds a critical value, self-electrostatic stiction failure of the switch occurs; the arc discharge that occurs at the moment of contact opening may cause the contact material to melt, causing a significant increase in contact resistance or even direct adhesion between the contact and the conductive line; when high-energy power passes through the switch, an enough electrostatic force is coupled between the upper and lower contacts or electrode plates so that self-lock and pull-in of the switch occur. Generally, the processing power of the RF MEMS electrostatic switch is below 1 W, while the processing power of the semiconductor switch may reach 1 to 10 W. The above is one of the main reasons affecting the reliability and application field of the RF MEMS. Compared with traditional semiconductor switches, the service life of the RF MEMS electrostatic switch is more than two orders of magnitude shorter. In addition, the current standard voltage used in integrated circuit (IC) systems is lower than 5 V, while the drive voltage of the RF MEMS electrostatic switch is generally between 10 V to 80 V, which is why RF MEMS electrostatic switches are rarely applied in mobile phone wireless communication systems. To sum up, improving the power handling capability, reducing the drive voltage, and improving the reliability are key issues to be solved urgently for the further development of the RF MEMS electrostatic switches.

US 5 121 089 A1 discloses a miniature electrostatically actuated switch being operable to connect and disconnect one or more transmission lines laid down on a dielectric substrate of an integrated circuit wafer. The switch includes a rotating switch blade which rotates about a hub formed on the dielectric substrate under the influence of electrostatic fields created by control pads and other control elements formed on the dielectric substrate.

Superlubricity technology studies the friction-free and wear-free sliding phenomenon between two or the same materials. The initial study is limited to nano-scale superlubricity phenomena, such as the superlubricity between multi-arm coaxial carbon nanotubes and the superlubricity between nanoprobes and two-dimensional materials. In 2013, Professor Quanshui Zheng discovered a superlubricity phenomenon between highly oriented pyrolytic graphite (HOPG) sheet materials at a micron scale for the first time, which marked the transition of the superlubricity from the basic research to the applicable technical research. According to a principle of the superlubric structure, the present disclosure proposes an in-plane sliding parallel capacitive RF switch, so as to reduce the drive voltage and greatly improve the service life and power handling capability of the switch.

The article by Xuanyu Huang et al.: "Superlubric Nanogenerators with Superb Performances" (ARXIV.ORG, CORNELL UNIVERSITY LIBRARY, 201 OLINE LIBRARY CORNELL UNIVERSITY ITHACA, NY 14853, 12 November 2019) relates to superlubric nanogenerators with superb performances and shows an nanogenerator with an upper electrode being disposed on a top surface of a substrate and two other electrodes being disposed in the substrate along a direction perpendicular to the top surface of the substrate. When a voltage is applied to the two electrodes in the substrate, the upper electrode does not move, and when the upper electrode and the lower electrode (i.e., an electrode in the substrate) are connected by a conductive circuit with an electric resistance, the upper electrode is moving in a direction parallel to the top surface of the substrate.

### SUMMARY

For shortcomings in the existing art, an object of the present disclosure is to provide an in-plane sliding parallel capacitive RF switch based on a superlubric structure according to the low-friction and wear-free in-plane sliding motion between a superlubric structure and a flat heterogeneous substrate.

The object is solved by an in-plane sliding parallel capacitive RF switch according to claim 1. Further embodiments of the invention are specified in the dependent claims.

To achieve the object of the present disclosure, technical solutions adopted by the present disclosure are an in-plane sliding parallel capacitive RF switch based on a superlubricity structure. The RF switch includes a substrate, a drive component, an insulating layer and a sliding component. Where a drive voltage is applied between two drive components, the sliding component slides to the top of the drive component under the action of a horizontal force; in this case, relatively large capacitance is formed between the drive component and the sliding component, a RF signal is almost completely reflected, and the transmission is cut off. Where the drive voltage is applied between the other drive component, the sliding component slides to the top of the other drive component under the action of a horizontal force; in this case, no facing area between the previous drive component and the sliding component exists in the vertical direction, the capacitance is rather small, and the RF signal may be transmitted basically without loss.

In the present disclosure, a sandwich structure consisting of the drive component, the insulating layer and the sliding component achieves wear-free sliding of the sliding component on the surface of the flat insulating layer with extremely low friction. In a disconnected state, the capacitance between the sliding component and the drive component is extremely small so that almost no loss of the RF signal exists; in a closed state, the sliding component and the drive component form relatively large capacitance due to the nanoscale insulating layer, and the RF signal is completely reflected. Voltage control timing is set so as to control the on-off of the RF switch.

In the present disclosure, a relatively low drive voltage, an extremely long service life and a high power handling capability may be achieved due to extremely low friction and no wear, and a major obstacle that restricts the service life of RF MEMS electrostatic switches is expected to be broken through, thereby promoting the practical process of the RF MEMS electrostatic switches and promoting the leap-forward development of research on related electronic equipment such as wireless communication systems (5G), high-performance phased array radars, and satellite communication systems.

### BRIEF DESCRIPTION OF DRAWINGS

FIG. 1 is a schematic diagram of a conducting state of a parallel capacitive RF switch according to the present disclosure;
FIG. 2 is a top diagram of a conducting state of a parallel capacitive RF switch according to the present disclosure;
FIG. 3 is a schematic diagram of a non-conducting state of a parallel capacitive RF switch according to the present disclosure;
FIG. 4 is a top diagram of a non-conducting state of a parallel capacitive RF switch according to the present disclosure; and
FIG. 5 is a sectional diagram of a substrate of an embedded drive electrode of a parallel capacitive RF switch according to the present disclosure.

### Reference list

- 1: HOPG SUPERLUBRIC SLICE
- 2: insulating layer
- 3: substrate
- 4: first drive electrode
- 5: second drive electrode
- 6: third drive electrode

### DETAILED DESCRIPTION

The superlubric slice in the present disclosure is part of a superlubric slider in the existing art. During relative sliding between two contact surfaces of the existing superlubric sliders, the friction is almost zero, a friction coefficient is less than one thousandth, and wear is zero.

For example, an existing preparation method of the superlubric slice based on the HOPG is specifically described below.

In step 1, the HOPG is covered with the photoresist. For example, the HOPG is covered by the photoresist through spin-coating.

In step 2, the photoresist is patterned and multiple photoresist mesas are retained in the patterned photoresist. The step of patterning the photoresist determines the layout of the graphite mesas formed in the subsequent steps. For example, the photoresist may be patterned by an electron beam etching method, an average size of the formed photoresist mesas may be, for example, 1 µm to 30 µm, and an average interval between the photoresist mesas is 1 µm to 100 µm so that the etched graphite mesas also have corresponding average diameters and average intervals.

In step 3, a substrate is etched and part of the substrate that is not protected by the photoresist is removed, so as to form multiple graphite mesas. The etching method may be, for example, reactive ion etching (RIE).

In step 4, the multiple graphite mesas are cleaved one by one by a mechanical arm to check whether the graphite sliders have superlubric slices. On a lower surface of the graphite mesa with self-healing properties, an HOPG slice with the superlubric shear surface is the superlubric slice.

Embodiments of the present disclosure are further described below with reference to the drawings.

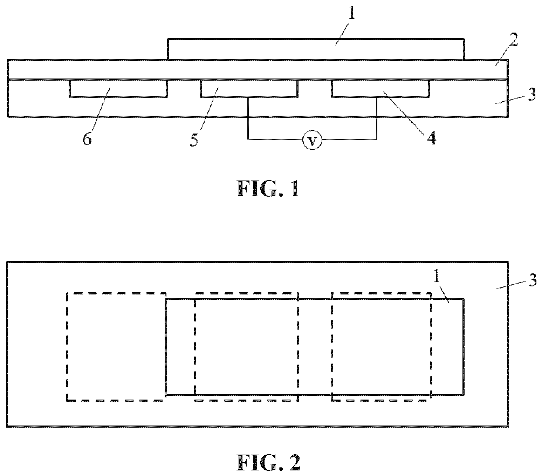

As shown in FIG. 1, the in-plane sliding parallel capacitive RF switch is composed of a high-resistance silicon substrate 3, a first drive electrode 4, a second drive electrode 5, a third drive electrode 6, an insulating layer 2, and an HOPG superlubric slice 1. The first drive electrode 4, the second drive electrode 5, and the third drive electrode 6 are embedded in the substrate 3. A surface of the substrate 3 and surfaces of the first drive electrode 4, the second drive electrode 5, and the third drive electrode 6 are flush and remain atomically flat. The insulating layer 2 covers the first drive electrode 4, the second drive electrode 5, and the third drive electrode 6 and is used for insulating between the HOPG superlubric slice and the first drive electrode 4, the second drive electrode 5 and the third drive electrode 6. A thickness of the insulating layer 2 is controlled between 2 nm to 50 nm so that a gap between the first drive electrode 4, the second drive electrode 5 and the third drive electrode 6 and the superlubric slice 1 is small enough, thereby ensuring a relatively small excitation voltage. Alternatively, the thickness of the insulating layer 2 may be controlled between 2 nm to 200 nm. The HOPG superlubric slice 1 is disposed on the insulating layer so as to form a superlubric slider with the insulating layer 2. An initial position of the superlubric slice 1 faces the first drive electrode 4. Since the HOPG superlubric slice 1 has a flat superlubric surface in the atomic scale, the HOPG superlubric slice 1 may slide on the surface of the insulating layer 2 with extremely low friction and without wear; and at the same time, adhesion failure due to charge accumulation on the electrode does not occur, thereby achieving an ultra-long service life.

A working process of the in-plane sliding parallel capacitive RF switch is described below. FIGS. 1 and 2 show that the RF switch is in a conducting state. A drive voltage V is applied between the first drive electrode 4 and the second drive electrode 5. In this case, left and right ends of the HOPG superlubric slice 1 induce charges to generate a floating potential, and the HOPG superlubric slice 1 moves toward a position where the potential energy is the smallest, that is, a centrosymmetric position of the first drive electrode 4 and the second drive electrode 5. In this case, between the HOPG superlubric slice 1 and the third drive electrode 6, since no overlapping area in a vertical direction exists, the capacitance is close to zero, and RF signals can all pass through without reflection loss.

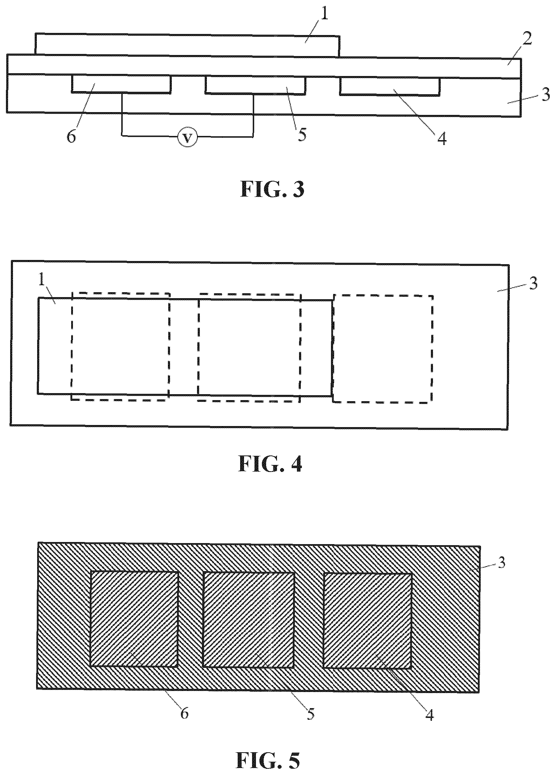

In the case where the drive voltage V is applied between the second drive electrode 5 and the third drive electrode 6 as shown in FIGS. 3 and 4, the HOPG superlubric slice 1 is subjected to a leftward force and pulled to a centrosymmetric position of the second drive electrode 5 and the third drive electrode 6. Since the thickness of the insulating layer 2 is nanoscale, a relatively large capacitance is formed between the HOPG superlubric slice 1 and the third drive electrode 6, the RF signals are completely reflected, and the transmission is cut off.

The number, arrangement, and timing control of the drive electrodes and the size of the HOPG superlubric slice are adjusted so as to achieve the in-plane continuous sliding of the HOPG superlubric slice.

## Claims

1. An in-plane sliding parallel capacitive radio frequency, RF, switch, comprising:
a drive component (4, 5, 6) which is disposed in a substrate (3) and comprises a first drive component (4), a second drive component (5), and a third drive component (6) which extend adjacent to each other in a horizontal direction parallel to a top surface of the substrate (3);
an insulating layer (2) which is disposed on the top surface of the substrate (3);
a sliding component (1) which has a superlubric interface, is disposed on the insulating layer (2), and contacts with the insulating layer (2) through the superlubric interface;
wherein the drive component (4, 5, 6) is configured to, in response to a voltage applied between two adjacent drive components (4, 5, 6), move the sliding component (1) toward a centrosymmetric position of the two adjacent drive components (4, 5, 6) in the horizontal direction.

2. The RF switch of claim 1, wherein the sliding component (1) is capable of being driven to slide along the horizontal direction in a plane, and overlapping and separation of the drive component (4, 5, 6) and the sliding component (1) in a vertical plane is adjusted to achieve switching.

3. The RF switch of claim 1 or 2, wherein the drive component (4, 5, 6) is a drive electrode.

4. The RF switch of any one of claims 1 to 3, wherein the sliding component (1) is a superlubric slice (1) with a superlubric surface.

5. The RF switch of claim 4, wherein the sliding component is a highly oriented pyrolytic graphite, HOPG, superlubric slice (1).

6. The RF switch of any one of claims 1 to 5, wherein the substrate (3) is an insulating material or a semiconductor material.

7. The RF switch of claim 6, wherein the semiconductor material is high-resistance silicon; and the insulating material is SiO₂, SiC, sapphire, or mica.

8. The RF switch of any one of claims 1 to 7, wherein the insulating layer (2) is a silicon oxide layer.

9. The RF switch of any one of claims 1 to 8, wherein the insulating layer (2) is smooth in atomic scale and has a thickness of 1 to 100 nanometers.

10. The RF switch of claim 9, wherein the insulating layer (2) has a thickness of 2 to 50 nanometers.

11. The RF switch of any one of claims 1 to 10, wherein the sliding component (1) is driven through electrostatic drive.

## Patentansprüche

1. In-Plane-Gleit-Parallel-Kapazitiv-Hochfrequenz (RF)-Schalter, umfassend:
eine Antriebskomponente (4, 5, 6), die in einem Substrat (3) angeordnet ist und eine erste Antriebskomponente (4), eine zweite Antriebskomponente (5) und eine dritte Antriebskomponente (6) umfasst, die sich benachbart zueinander in einer horizontalen Richtung parallel zu einer Oberseite des Substrats (3) erstrecken;
eine Isolierschicht (2), die auf der Oberseite des Substrats (3) angeordnet ist;
eine Gleitkomponente (1), die eine superschlüpfrige Grenzfläche aufweist, auf der Isolierschicht (2) angeordnet ist und über die superschlüpfrige Grenzfläche mit der Isolierschicht (2) in Kontakt steht;
wobei die Antriebskomponente (4, 5, 6) dazu konfiguriert ist, als Reaktion auf eine zwischen zwei benachbarten Antriebskomponenten (4, 5, 6) angelegte Spannung die Gleitkomponente (1) in horizontaler Richtung in Richtung einer zentrosymmetrischen Position der beiden benachbarten Antriebskomponenten (4, 5, 6) zu bewegen.

2. RF-Schalter nach Anspruch 1, wobei die Gleitkomponente (1) so angetrieben werden kann, dass sie entlang der horizontalen Richtung in einer Ebene gleitet, und wobei das Überlappen und Trennen der Antriebskomponente (4, 5, 6) und der Gleitkomponente (1) in einer vertikalen Ebene so eingestellt wird, dass eine Umschaltung erreicht wird.

3. RF-Schalter nach Anspruch 1 oder 2, wobei die Antriebskomponente (4, 5, 6) eine Antriebselektrode ist.

4. RF-Schalter nach einem der Ansprüche 1 bis 3, wobei die Gleitkomponente (1) eine superschlüpfrige Scheibe (1) mit einer superschlüpfrigen Oberfläche ist.

5. RF-Schalter nach Anspruch 4, wobei die Gleitkomponente eine superschlüpfrige, hochorientierte pyrolytische Graphit (HOPG)-Scheibe (1) ist.

6. RF-Schalter nach einem der Ansprüche 1 bis 5, wobei das Substrat (3) ein Isoliermaterial oder ein Halbleitermaterial ist.

7. RF-Schalter nach Anspruch 6, wobei das Halbleitermaterial hochohmiges Silizium und das Isoliermaterial SiO₂, SiC, Saphir oder Glimmer ist.

8. RF-Schalter nach einem der Ansprüche 1 bis 7, wobei die Isolierschicht (2) eine Siliziumoxidschicht ist.

9. RF-Schalter nach einem der Ansprüche 1 bis 8, wobei die Isolierschicht (2) auf atomarer Ebene glatt ist und eine Dicke von 1 bis 100 Nanometern aufweist.

10. RF-Schalter nach Anspruch 9, wobei die Isolierschicht (2) eine Dicke von 2 bis 50 Nanometern aufweist.

11. RF-Schalter nach einem der Ansprüche 1 bis 10, wobei die Gleitkomponente (1) durch einen elektrostatischen Antrieb angetrieben wird.

## Revendications

1. Commutateur capacitif parallèle coulissant dans un plan à fréquence radio, RF, comprenant :
un élément d'entraînement (4, 5, 6) qui est disposé dans un substrat (3) et comprend un premier élément d'entraînement (4), un deuxième élément d'entraînement (5), et un troisième élément d'entraînement (6) qui s'étendent adjacents l'un à l'autre dans une direction horizontale à une surface supérieure du substrat (3) ;
une couche isolante (2) qui est disposée sur la surface supérieure du substrat (3) ;
un élément coulissant (1) qui a une interface superlubrifiante, est disposé sur la couche isolante (2), et en contact avec la couche isolante (2) à travers l'interface superlubrifiante ;
dans lequel l'élément d'entraînement (4, 5, 6) est configuré pour, en réponse à un voltage appliqué entre deux éléments d'entraînement (4, 5, 6) adjacents, déplacer l'élément coulissant (1) vers une position centrosymétrique des deux éléments d'entraînement (4, 5, 6) adjacents dans la direction horizontale.

2. Commutateur RF selon la revendication 1, dans lequel l'élément coulissant (1) est capable d'être entraîné pour coulisser le long de la direction horizontale dans un plan, et un chevauchement et une séparation de l'élément d'entraînement (4, 5, 6) et l'élément coulissant (1) dans un plan vertical est ajusté pour réaliser une commutation.

3. Commutateur RF selon la revendication 1 ou 2, dans lequel l'élément d'entraînement (4, 5, 6) est une électrode d'entraînement.

4. Commutateur RF selon l'une quelconque des revendications 1 à 3, dans lequel l'élément coulissant (1) est une tranche superlubrifiante (1) avec une surface superlubrifiante.

5. Commutateur RF selon la revendication 4, dans lequel l'élément coulissant est une tranche superlubrifiante (1) de graphite pyrolytique hautement orienté, HOPG.

6. Commutateur RF selon l'une quelconque des revendications 1 à 5, dans lequel le substrat (3) est un matériau isolant ou un matériau semi-conducteur.

7. Commutateur RF selon la revendication 6, dans lequel le matériau semi-conducteur est du silicium à haute résistance ; et le matériau isolant est du SiO₂, du SiC, du saphir, ou du mica.

8. Commutateur RF selon l'une quelconque des revendications 1 à 7, dans lequel la couche isolante (2) est une couche d'oxyde de silicium.

9. Commutateur RF selon l'une quelconque des revendications 1 à 8, dans lequel la couche isolante (2) est lisse à l'échelle atomique et a une épaisseur de 1 à 100 nanomètres.

10. Commutateur RF selon la revendication 9, dans lequel la couche isolante (2) a une épaisseur de 2 à 50 nanomètres.

11. Commutateur RF selon l'une quelconque des revendications 1 à 10, dans lequel l'élément coulissant (1) est entraîné à travers un entraînement électrostatique.
